(19) **Europäisches Patentamt / European Patent Office / Office européen des brevets**

(11) **EP 4 199 339 B1**

(12) **FASCICULE DE BREVET EUROPEEN**

(45) Date de publication et mention de la délivrance du brevet:
**26.03.2025 Bulletin 2025/13**

(21) Numéro de dépôt: **22213302.7**

(22) Date de dépôt: **14.12.2022**

(51) Classification Internationale des Brevets (IPC):
***H02N 2/18*** *(2006.01)* ***H03H 9/17*** *(2006.01)*

(52) Classification Coopérative des Brevets (CPC):
**H02N 2/18; H02N 2/181**

(54) **SYSTEME PIEZOELECTRIQUE**

**PIEZOELEKTRISCHES SYSTEM**

**PIEZOELECTRIC SYSTEM**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **20.12.2021 FR 2113997**

(43) Date de publication de la demande:
**21.06.2023 Bulletin 2023/25**

(73) Titulaire: **Commissariat à l'Energie Atomique et aux Energies Alternatives**
**75015 Paris (FR)**

(72) Inventeurs:
• **PILLONNET, Gaël**
**38054 GRENOBLE Cedex 09 (FR)**
• **MOREL, Adrien**
**38054 GRENOBLE Cedex 09 (FR)**
• **MANOKHIN, Mikhail**
**38059 GRENOBLE Cedex 09 (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**WO-A1-2019/073066 FR-A1- 2 962 613**
**US-A1- 2007 103 650**

**Description**

## DOMAINE TECHNIQUE

Le domaine technique de la présente invention concerne le domaine des résonateurs piézoélectriques, et en particulier, les systèmes comprenant un résonateur piézoélectrique et permettant l'ajustement des signaux piézoélectriques aux bornes du résonateur piézoélectrique.

## ARRIÈRE-PLAN

Les résonateurs piézoélectriques permettent de convertir un mouvement du résonateur dû à l'application d'une force, d'une contrainte ou d'une pression, en énergie électrique. Ils sont utilisés dans une grande gamme d'applications telles que les transducteurs ultrasonores, les oscillateurs à quartz et les gyroscopes. Cependant, le phénomène de résonance des résonateurs piézoélectriques n'est efficace que sur une faible plage de fréquences dont la largeur fréquentielle est inversement proportionnelle au facteur de qualité, limitant la bande passante des résonateurs piézoélectriques. En dehors de la bande passante, la sensibilité des résonateurs piézoélectriques est fortement diminuée. La sensibilité des résonateurs piézoélectriques est également proportionnelle au facteur de qualité. Par conséquent, si le facteur de qualité est élevé (et donc la plage de fréquences limitée), la variation de paramètres mécaniques tels que la température ou le vieillissement des résonateurs, entraine une variation de la fréquence de résonnance et/ou de la bande passante. En outre, à une fréquence d'excitation donnée, la fréquence de résonance peut donc sortir de la bande passante et le signal électrique issu du résonateur en est fortement affaibli.

Il existe de nombreuses solutions dans l'état de l'art. Par exemple, il est possible d'ajuster électriquement le résonateur en mettant en oeuvre un couplage électromécanique supplémentaire permettant d'ajuster sa fréquence de résonance. Cependant, l'application de ce couplage supplémentaire nécessite l'ajout d'une paire d'électrodes, limitant ainsi la surface active du résonateur piézoélectrique.

D'autres solutions proposent d'utiliser une calibration des résonateurs piézoélectriques. Cependant, la calibration ne permet pas l'optimisation en temps réel et donc l'adaptation à des changements soudains (en température par exemple).
US2007/103650 A1 divulgue un projecteur utilisant un dispositif de source lumineuse qui est allumé rapidement et de manière fiable et peut obtenir de manière stable une quantité de lumière souhaitée et un procédé pour allumer rapidement et de manière fiable un dispositif de source lumineuse d'un projecteur.
FR2962613 A1 divulgue un dispositif d'adaptation d'impédance d'un composant comportant au moins un filtre caractérisé en ce que ledit filtre est à impédance adaptable et comporte au moins deux résonateurs couplés à ondes acoustiques, au moins un des résonateurs comprenant un matériau de type pérovskite et des moyens pour appliquer une tension audit résonateur permettant d'en faire varier la permittivité et l'impédance.
WO2019/073066 A1 se réfère au procédé de pilotage d'un circuit de récupération d'énergie électrique produite par un transducteur piézoélectrique, formant un résonateur piézoélectrique sous l'effet de vibrations provenant d'une source d'excitation mécanique. Ce circuit produit une tension de sortie CC au moyen d'un convertisseur CC-CC fonctionnant à l'aide de PWM, qui est piloté par un signal qui contrôle son rapport cyclique avec une valeur de courant.

## RÉSUMÉ

Afin de pallier les inconvénients des résonateurs piézoélectriques existants, l'invention propose un système à résonateur piézoélectrique comprenant un asservissement en temps réel des paramètres du résonateur sans nécessiter la mise en oeuvre d'électrodes supplémentaires.

A cet effet, l'invention a pour objet de modifier les paramètres du résonateur piézoélectrique afin de maintenir dynamiquement la fréquence de résonnance du résonateur proche de sa fréquence d'excitation. Par exemple, une tension qui est proportionnelle à une force appliquée au résonateur peut être optimisée en utilisant une impédance active appliquée directement aux bornes des électrodes du résonateur. Ainsi, l'invention permet d'optimiser les performances du résonateur en compensant pour les variations externes a priori non connues, telles que les changements de température ou le vieillissement du résonateur, sans nécessiter une paire d'électrodes additionnelle ni l'addition de capteurs pour mesurer les variations externes.

L'invention vient améliorer la situation en proposant un système piézoélectrique selon l'objet de la revendication indépendante de dispositif 1.

Dans un mode de réalisation, le système comprend une unité de mémoire configurée pour sauvegarder les au moins deux signaux.

Dans un mode de réalisation, l'impédance active comprend une résistance et/ou une inductance et/ou une capacité.

Dans un mode de réalisation, l'unité d'impédance active comprend un amplificateur opérationnel.

Dans un mode de réalisation, l'unité de contrôle est configurée pour augmenter une valeur de capacité de l'impédance active quand un premier signal des au moins deux signaux est supérieur à un deuxième signal des au moins deux signaux, et réduire une valeur de capacité de l'impédance quand le premier signal est inférieur au deuxième signal, dans lequel le premier signal est détecté à un premier instant et le deuxième signal est détecté à un deuxième instant, le premier instant précédant le deuxième instant.

Dans un mode de réalisation, le détecteur est configuré pour attendre une durée prédéterminée entre la détection du premier signal et la détection du deuxième signal.

De plus, l'invention vient à améliorer la situation en proposant un procédé d'ajustement pour ajuster des signaux piézoélectriques d'un résonateur piézoélectrique comprenant un élément piézoélectrique et une paire d'électrodes configurées pour transmettre des signaux piézoélectriques émis par l'élément piézoélectrique et engendrés par une déformation de l'élément piézoélectrique, le procédé comprenant : détecter un premier signal des signaux piézoélectriques émis par l'élément piézoélectrique à un instant t ; détecter un deuxième signal des signaux piézoélectriques émis par l'élément piézoélectrique à un instant t+1, t étant différent de t+1; comparer le premier signal et le deuxième signal ; déterminer une valeur complexe d'impédance active sur la base de la comparaison et en fonction d'une loi prédéterminée; générer une impédance active connectée à la paire d'électrodes, l'impédance active étant basée sur la valeur complexe d'impédance active.

Dans un mode de réalisation, le procédé est répété successivement plusieurs fois et, chaque fois que le procédé est répété, le premier signal devient le deuxième signal.

Dans un mode de réalisation, le procédé est répété au moins trois fois et le premier signal, le deuxième signal et un troisième signal sont détectés successivement, le procédé comprenant : arrêter le procédé pendant une période prédéterminée quand le signal initial est sensiblement égal au troisième signal.

## BREVE DESCRIPTION DES DESSINS

L'invention sera mieux comprise et d'autres avantages apparaîtront à la lecture de la description qui va suivre donnée à titre non limitatif et grâce aux figures parmi lesquelles :

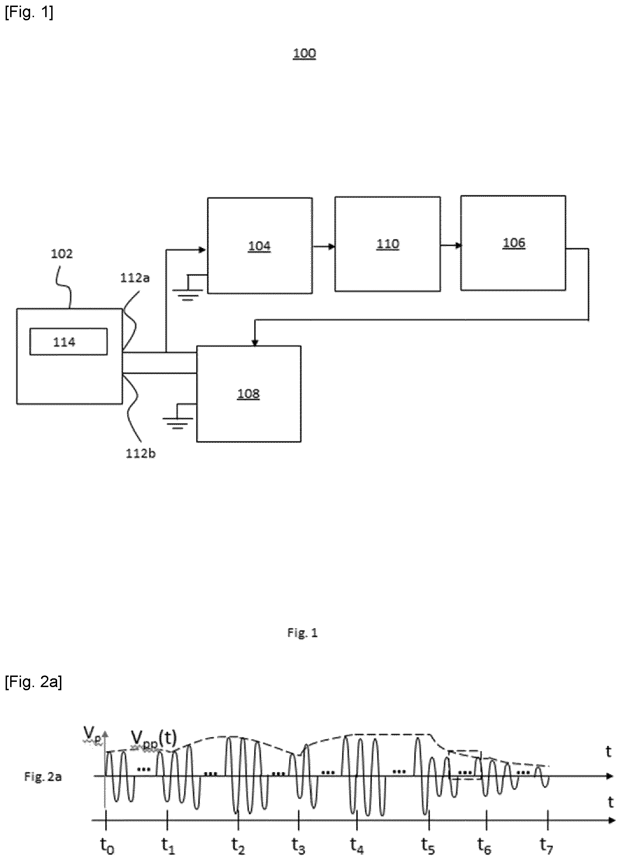

[Fig.1] la figure 1 illustre un exemple de système piézoélectrique ;

[Fig. 2a]

[Fig. 2b, 2c, 2d] les figures 2a, 2b, 2c et 2d illustrent des exemples d'ajustement de signaux piézoélectriques d'un résonateur piézoélectrique ;

[Fig. 3] la figure 3 illustre un exemple de réalisation d'impédance active ;

[Fig. 4] la figure 4 illustre un autre exemple de réalisation d'impédance active ;

[Fig. 5] la figure 5 illustre un autre exemple de réalisation d'impédance active ; et

[Fig. 6] la figure 6 illustre un exemple de procédé pour ajuster des signaux piézoélectrique d'un résonateur piézoélectrique.

## DESCRIPTION DÉTAILLÉE

La figure 1 illustre un système piézoélectrique 100 comprenant un résonateur piézoélectrique 102, un détecteur 104, une unité de contrôle 106 et une unité d'impédance active 108.

Le résonateur piézoélectrique 102 peut être par exemple, un transducteur ultrasonore, un diapason, un oscillateur à quartz ou un gyroscope. Le résonateur piézoélectrique 102 comprend un élément piézoélectrique 114 configuré pour émettre des signaux lorsqu'il est déformé. Par exemple, l'élément piézoélectrique 114 peut comporter une poutre adaptée à résonner mécaniquement à une fréquence d'excitation lorsqu'elle est soumise à une force, une pression ou une contrainte appliquée à la poutre. L'élément piézoélectrique 114 est conçu pour avoir une fréquence de résonnance qui est la fréquence propre de la bande passante de l'élément piézoélectrique 114. Cependant, la fréquence de résonnance des vibrations mécaniques émis par l'élément piézoélectrique 114 dépendent des forces appliquées mais aussi d'autres facteurs tels que :

- une conception imprécise du résonateur mécanique ;

- un vieillissement du résonateur piézoélectrique 102, conduisant par exemple à une modification de la rigidité de l'élément piézoélectrique 114;

- des variations de la température ambiante, modifiant des propriétés de l'élément piézoélectrique 114, et modifiant ainsi la fréquence de résonance.

Par conséquent, en pratique, comme la fréquence de résonnance varie au cours du temps, il est difficile de maintenir la fréquence d'excitation proche de la fréquence de résonnance.

Le résonateur piézoélectrique 102 convertit les oscillations mécaniques de l'élément piézoélectrique 114 en signaux électriques. En particulier, les signaux électriques forment par exemple une tension Vp qui est proportionnelle à la force appliquée sur l'élément piézoélectrique 114. Le résonateur piézoélectrique 102 comprend deux électrodes 112a, 112b configurées pour transmettre la tension Vp émise par l'élément piézoélectriques 114. Lorsque que la fréquence d'excitation change, la fréquence et l'amplitude de la tension Vp changent également en suivant une courbe de sensibilité du résonateur en fonction de la fréquence d'excitation.

Le détecteur 104 est configuré pour détecter au moins deux signaux des signaux engendrés par la déformation de l'élément piézoélectrique 114, les au moins deux signaux étant détectés à des instants différents. En particulier, le détecteur 104 peut être par exemple un détecteur de signaux crête à crête qui détecte une valeur crête à crête Vpp de la tension Vp présente entre les deux électrodes 112a, 112b. Le détecteur 104 détecte la tension Vp à des instants différents. Par exemple, le détecteur 104 peut détecter la tension Vp à un instant t et à un instant t+1. Par exemple, la figure 2a représente la tension Vp et la valeur crête à crête mesurées à différents instants. Dans l'exemple illustré dans la figure 2a, la tension Vp est détectée à des instants $t_0$, $t_1$, $t_2$, $t_3$, $t_4$, $t_5$, $t_6$ et $t_7$, par le détecteur 104 qui mesure une valeur crête à crête Vpp(t) à ces instants $t_0$, $t_1$, $t_2$, $t_3$, $t_4$, $t_5$, $t_6$ et $t_7$.

Le détecteur 104 peut être spécifique à la détection des signaux utilisés pour l'asservissement en temps réel de paramètres du résonateur 102. Alternativement, le détecteur 104 peut aussi être utilisé pour mesurer la tension Vp utilisée à d'autres fins comme par exemple la mesure de la fréquence d'excitation.

L'unité de contrôle 106 est configurée pour comparer les aux moins deux signaux et, sur la base de la comparaison, déterminer une valeur complexe d'impédance active $C_T$ en fonction d'une loi prédéterminée. L'unité de contrôle 106 peut être mise en oeuvre en utilisant des dispositifs informatiques, un logiciel et/ou une combinaison de ceux-ci. Par exemple, les dispositifs informatiques peuvent être mis en oeuvre à l'aide de circuits de traitement tels que, mais sans s'y limiter, un processeur, une unité centrale de traitement (CPU), un contrôleur, une unité arithmétique et logique (ALU), un processeur de signal numérique, un micro-ordinateur, un champ de réseau de portes programmable (FPGA), un système sur puce (SoC), une unité logique programmable, un microprocesseur ou tout autre dispositif capable de répondre et d'exécuter des instructions d'une manière définie. Le logiciel peut inclure un programme informatique, un code de programme, des instructions, ou une combinaison de ceux-ci, pour instruire ou configurer indépendamment ou collectivement un dispositif matériel pour qu'il fonctionne comme souhaité. Le programme informatique et/ou le code de programme peuvent comprendre des instructions de programme ou lisibles par ordinateur, des composants logiciels, des modules logiciels, des fichiers de données, des structures de données et/ou similaires, pouvant être mis en oeuvre par un ou plusieurs dispositifs matériels, tels qu'un ou plus des périphériques matériels mentionnés ci-dessus. Lorsqu'un dispositif matériel est un dispositif de traitement informatique (par exemple, CPU, un contrôleur, une ALU, un processeur de signal numérique, un micro-ordinateur, un microprocesseur, etc.), le dispositif de traitement informatique peut être configuré pour exécuter un code de programme en effectuant des opérations arithmétiques, opérations logiques et d'entrée/sortie, selon le code du programme.

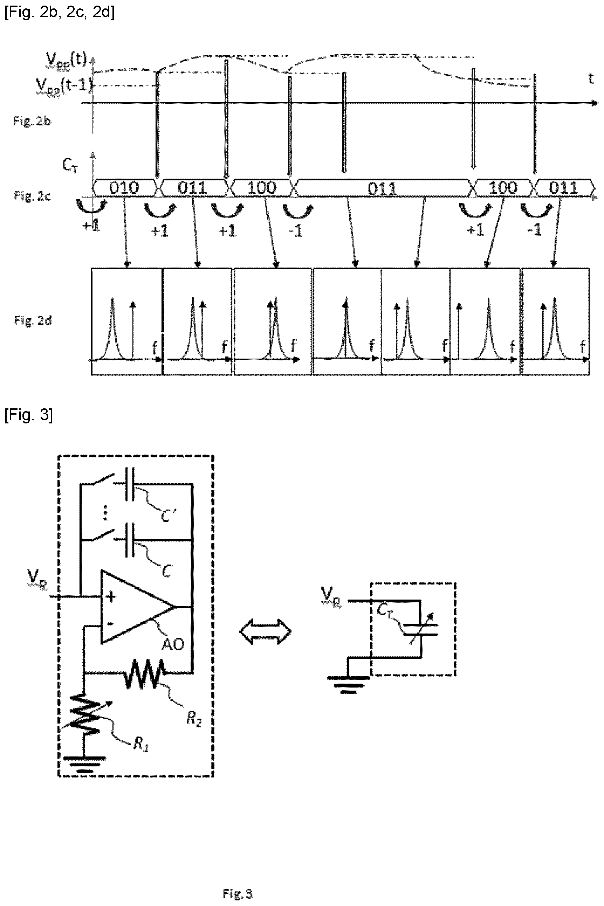

Par exemple, l'unité de contrôle 106 reçoit au moins deux valeurs crête à crête Vpp(t) du détecteur 104 et compare les valeurs reçues. Par exemple, comme indiqué ci-dessus et illustré dans la figure 2a, le détecteur 104 détecte des valeurs crête à crête Vpp(t) aux instants $t_0$, $t_1$, $t_2$, $t_3$, $t_4$, $t_5$, $t_6$ et $t_7$. Comme illustré dans la figure 2b, l'unité de contrôle 106 compare la valeur crête à crête Vpp($t_{-1}$) à la valeur crête à crête Vpp($t_0$). En effet, la première valeur de Vpp(t) dans la figure 2b indique qu'une valeur Vpp($t_{-1}$) a été mesurée à un instant t. 1. De même, l'unité de contrôle 106 compare la valeur crête à crête Vpp($t_0$) à la valeur crête à crête Vpp($t_1$), la valeur crête à crête Vpp($t_1$) à la valeur crête à crête Vpp($t_2$) ... et la valeur crête à crête Vpp($t_5$) à la valeur crête à crête Vpp($t_6$).

Comme illustré dans la figure 2b, l'unité de contrôle 106 peut être est configurée pour attendre une durée permettant à la tension Vp de se stabiliser avant de comparer les valeurs crête à crête à deux instants différents. En effet, cela permet au résonateur piézoélectrique 102 d'atteindre un régime établi avant de comparer les valeurs des signaux détectés.

L'unité de contrôle 106 est également configurée pour déterminer une valeur complexe d'impédance active $C_T$ en fonction d'une loi prédéterminée sur la base de la comparaison. De plus, l'unité d'impédance active 108 est configurée pour générer une impédance active $C_T$ basée sur la valeur complexe d'impédance active $C_T$ déterminée par l'unité de contrôle 106. L'impédance active est ensuite appliquée au résonateur piézoélectrique 102 par la paire d'électrodes 112a, 112b qui est connectée à l'unité d'impédance active 108. En pratique, l'impédance active se combine avec l'impédance intrinsèque du résonateur 102 vue entre les deux électrodes 112a et 112b. La combinaison des deux impédances peut se faire par une mise en série ou en parallèle des deux impédances. Ainsi, une impédance active est appliquée au résonateur piézoélectrique 102 afin de modifier les paramètres du résonateur, par exemple, modifier la tension Vp.

La loi prédéterminée peut être appliquée par un algorithme qui détermine la valeur complexe d'impédance active $C_T$ par essais successifs et itération. Par exemple, la loi prédéterminée peut dépendre par exemple du résonateur piézoélectrique 102 ou peut être basée sur une table de correspondance comprenant des valeurs prédéterminées. **En** particulier, la loi prédéterminée peut minimiser ou maximiser la tension Vp ou rendre la tension Vp supérieure à une valeur prédéterminée afin de moduler la sensibilité du capteur à la fréquence d'excitation. Par exemple, une fonction de transfert comprenant une relation entre la tension Vp et une excitation mécanique extérieure sur l'élément piézoélectrique peut être déterminée et maximisée. Par exemple, la loi prédéterminée peut être exécutée par un algorithme qui détermine une valeur d'impédance active $C_T$ supérieure à la valeur précédente quand la valeur crête à crête à un premier instant est inférieure à la valeur crête à crête à un deuxième instant. De même, l'algorithme peut déterminer une valeur d'impédance active $C_T$ inférieure à la valeur précédente quand la valeur crête à crête à un premier instant est supérieure à la valeur crête à crête à un deuxième instant. De façon générale, comme illustré dans la figure 2c, l'unité d'impédance active 108 est configurée pour incrémenter l'impédance active $C_T$ dans un sens ou décrémenter l'impédance active $C_T$ dans l'autre sens, dépendamment de la comparaison entre les valeurs crête à crête à deux instants.

En considérant par exemple la comparaison entre la valeur crête à crête Vpp à l'instant $t_0$ à la valeur crête à crête Vpp à l'instant $t_1$, l'unité de contrôle 106 détermine que la valeur crête à crête $Vpp(t_0)$ est inférieure à la valeur crête à crête $Vpp(t_1)$. Ainsi, l'unité de contrôle 106 détermine une valeur complexe d'impédance active $C_T$ transmise à l'unité d'impédance active 108 qui, lorsque appliquée au résonateur piézoélectrique 102 par l'unité d'impédance active 108, modifie la valeur Vp. Comme l'unité de contrôle 106 détermine que la valeur crête à crête Vpp à l'instant $t_0$ est inférieure à la valeur crête à crête Vpp à l'instant $t_1$, cela indique que la tension Vp à l'instant $t_0$ n'est pas maximisée.

La figure 2d représente des graphiques de l'amplitude de la tension Vp en fonction de la fréquence à des instants $t_0$ à $t_7$. Dans chaque graphique, la fréquence d'excitation est représentée par une flèche verticale, et la fréquence de résonance est représentée par une courbe de type gaussienne où la fréquence de résonance est matérialisée par le sommet de la courbe.

Comme illustré dans la figure 2d, les fréquences de résonnance et d'excitation peuvent différer. Il peut être souhaitable de rapprocher ces deux fréquences afin de maximiser la tension Vp. Afin de maximiser la tension Vp à l'instant $t_1$, l'unité de contrôle 106 considère que si la valeur Vpp à un instant $t_0$ est inférieure à celle à un instant $t_1$, l'unité de contrôle 106 incrémente la valeur d'impédance active $C_T$ dans un sens. Dans l'exemple de la figure 2c, la valeur d'impédance active $C_T$ est incrémentée dans le même sens que la valeur d'impédance active $C_T$ qui a été appliquée au résonateur piézoélectrique 102 à l'instant $t_0$. Par exemple, à l'instant $t_1$, une valeur d'impédance active $C_T$ supérieure à celle à l'instant $t_0$ peut être appliquée au résonateur piézoélectrique 102. Les incrémentations représentées dans la figure 2c représentent des valeurs binaires associées à des valeurs d'impédance active. Le pas entre deux incrémentations successives peut être par exemple régulier.

De même, comme l'unité de contrôle 106 détermine que la valeur crête à crête $Vpp(t_1)$ est inférieure à la valeur crête à crête $Vpp(t_2)$. Comme illustré dans la figure 2d, tension Vp n'est pas maximisée entre les instants $t_1$ et $t_2$ car la fréquence d'excitation et la fréquence de résonance diffèrent. Ainsi, l'unité de contrôle 106 incrémente la valeur d'impédance active $C_T$ dans le même sens que la valeur d'impédance active $C_T$ qui a été appliquée au résonateur piézoélectrique 102 à l'instant $t_1$. Par exemple, à l'instant $t_2$, une valeur d'impédance active $C_T$ supérieure à celle à l'instant $t_0$ peut être appliquée au résonateur piézoélectrique 102.

Cependant, comme indiqué dans la figure 2b, la valeur crête à crête $Vpp(t_2)$ est supérieure à la valeur crête à crête $Vpp(t_1)$. La baisse de la valeur crête à crête Vpp indique que la valeur optimale de Vp a été dépassée. Ainsi, l'unité de contrôle 106 incrémente la valeur d'impédance active dans le sens opposé à celle qui a été appliquée au résonateur piézoélectrique 102 à l'instant $t_2$. Par exemple, à l'instant $t_3$, une valeur d'impédance active $C_T$ supérieure à celle à l'instant $t_0$ peut être appliquée au résonateur piézoélectrique 102. Ainsi, comme indiquée dans la figure 2d, quand la valeur Vp est maximisée car la valeur de la fréquence d'excitation est égale à la fréquence de résonance de l'élément piézoélectrique.

Comme la valeur Vp maximale est atteinte, l'unité de contrôle 106 peut cesser de déterminer une valeur d'impédance active $C_T$ lorsque les signaux restent constants. Alternativement, le détecteur 104 peut être configuré pour attendre une durée prédéterminée entre la détection d'un autre signal. Le détecteur 104 peut être arrêté par exemple. De même, l'unité de contrôle 106 peut être également arrêtée pour la même durée prédéterminée. Ainsi, le système 100 peut être mis en pause pendant une durée pendant que la valeur Vp est maximale. La durée prédéterminée peut être basée sur le type de résonateur piézoélectrique 102 par exemple.

Dans un autre exemple, comme indiqué ci-dessus, au lieu de centrer la fréquence de résonnance sur la fréquence d'excitation, il est possible de maximiser une fonction de transfert comprenant une relation entre la tension Vp et une excitation mécanique extérieure sur l'élément piézoélectrique.

Dans un autre exemple, au lieu de déterminer des valeurs d'impédance active $C_T$ discrètes, comme indiqué ci-dessus, l'unité de contrôle 106 peut déterminer des valeurs d'impédance active continues. Par exemple, l'unité de contrôle 106 peut déterminer une plage de valeurs et l'unité d'impédance active 108 peut générer des impédances actives dans cette plage.

Comme indiqué dans la figure 2d, lorsque la tension Vp est modifiée par l'application de l'impédance active, la fréquence de résonnance est modifiée. Afin d'optimiser le résonateur, la fréquence de résonnance doit être proche de la fréquence d'excitation. A l'instant $t_5$, la fréquence d'excitation peut à nouveau différer de la fréquence de résonnance, sans changer l'impédance active. Ce changement peut être engendré par exemple par un changement de température ou le vieillissement du résonateur piézoélectrique 102. Lorsque qu'un changement apparait, l'unité de contrôle 106 détermine une nouvelle valeur d'impédance active $C_T$ qui est appliquée au résonateur piézoélectrique 102 et le processus est répété jusqu'à ce que la valeur Vp soit de nouveau maximale.

Ainsi, comme indiqué dans la figure 2b, la valeur crête à crête $Vpp(t_5)$ est comparée à la valeur crête à crête $Vpp(t_6)$ et une nouvelle impédance active est appliquée au résonateur piézoélectrique 102 afin de maximiser de nouveau la tension Vp.

En outre, le processus réalisé par le système 100 décrit ci-dessus peut-être répété afin de maximiser la valeur Vp en temps réel et de maintenir la fréquence de résonnance proche de la fréquence de d'excitation. Cela permet de maximiser la sensibilité du résonateur piézoélectrique 102 qui a été rapprochée de la fréquence d'excitation et ainsi d'optimiser le fonctionnement du résonateur piézoélectrique 102 en fonction des facteurs tels que les changements de températures et le vieillissement. L'optimisation peut être réalisée en temps réel et sans faire de calibration. De plus, il faut noter que dans les exemples ci-dessus, l'application d'une impédance active au résonateur piézoélectrique 102 par la paire d'électrodes 112a, 112b modifie la fréquence de résonance globale (incluant la fréquence propre et une impédance électrique) ainsi que le facteur de qualité du résonateur piézoélectrique 102.

Facultativement, le système piézoélectrique 100 comprend une unité de mémoire 110 configurée pour sauvegarder les au moins deux signaux. L'unité de contrôle 106 peut également comprendre un ou plusieurs dispositifs de stockage tels que l'unité de mémoire 110. Le ou les dispositifs de stockage peuvent être des supports de stockage lisibles par ordinateur tangibles ou non transitoires, tels qu'une mémoire vive (RAM), une mémoire morte (ROM), un dispositif de stockage de masse permanent (tel qu'un lecteur de disque), un (par exemple, flash NAND) et/ou tout autre mécanisme de stockage de données similaire capable de stocker et d'enregistrer des données. De plus, le ou les dispositifs de stockage peuvent correspondre à des accès à des services informatiques déportés via un réseau Internet, connus en anglais sous le nom de « *Cloud* ». Le ou les dispositifs de stockage peuvent être configurés pour stocker des programmes informatiques, un code de programme, des instructions ou une combinaison de ceux-ci, pour un ou plusieurs systèmes d'exploitation et/ou pour mettre en œuvre les exemples de modes de réalisation décrits ici. Les programmes informatiques, le code de programme, les instructions ou une combinaison de ceux-ci peuvent également être chargés à partir d'un support de stockage lisible par ordinateur séparé dans le ou les dispositifs de stockage et/ou un ou plusieurs dispositifs de traitement informatique à l'aide d'un mécanisme d'entraînement. Un tel support de stockage lisible par ordinateur séparé peut comprendre une clé USB (Universal Serial Bus), une clé mémoire, un lecteur Blu-ray/DVD/CD-ROM, une carte mémoire et/ou d'autres supports de stockage lisibles par ordinateur.

Par exemple, le détecteur peut transmettre la valeur crête à crête Vpp détectée à la mémoire 110 après chaque détection. La mémoire 110 peut ensuite transmettre les valeurs Vpp à l'unité de contrôle 106 qui réalise ensuite la comparaison entre les valeurs Vpp.

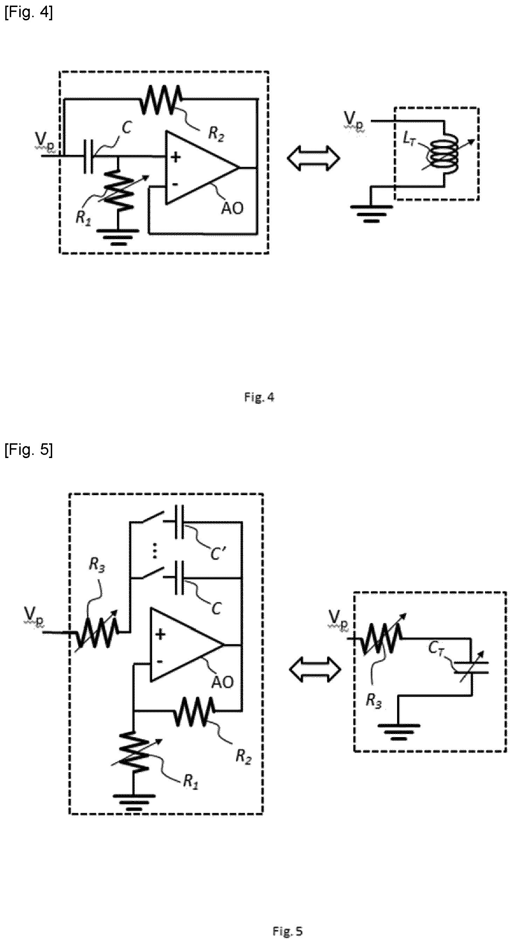

Deux exemples d'unités d'impédance active 108 sont illustrés dans les figures 3 et 4. L'unité d'impédance active 108 comprend une résistance et/ou une inductance et/ou une capacité. En particulier, l'impédance active peut être générée avec une capacité de valeur négative $C_T$ ou une inductance positive $L_T$.

La figure 3 représente un exemple d'unité d'impédance active 108 configurée pour permettre la génération d'une impédance active avec une capacité de valeur négative $C_T$. Dans cet exemple, l'inductance active comprend une résistance variable $R_1$, une résistance $R_2$, un amplificateur opérationnel AO, une capacité de valeur C et une capacité de valeur C' formant un banc de capacités arrangées en parallèle, et où $C' = 2^N \times C$. L'élément piézoélectrique 114 comprend une impédance piézoélectrique intrinsèque comprenant une capacité Cp. La stabilité du système est assurée quand la capacité C est inférieure à la capacité Cp. Pour changer la valeur de capacité de l'impédance active appliquée au résonateur piézoélectrique 102, la valeur de la résistance $R_1$ variable est changée. La résistance variable peut être, par exemple, un transistor dont la grille est modulée analogiquement. Par exemple, l'unité de contrôle 106, en déterminant la valeur d'impédance active $C_T$, peut déterminer la valeur de la résistance variable $R_1$ en

$$C_T = -\frac{R_1}{R_2}C$$

utilisant la relation : . Ainsi, afin d'optimiser les performances du résonateur, la capacité $C_T$ peut avantageusement varier de $-C_p$ à 0.

De plus, comme indiqué ci-dessus, la valeur de la résistance peut être changée afin d'obtenir des valeurs d'impédance active discrètes ou continues, c'est-à-dire des valeurs continues dans une plage déterminée par l'unité de contrôle 106.

Ainsi, comme indiqué dans la figure 3, la configuration illustrée simule une capacité de valeurs négatives variables qui permet de changer la tension Vp.

La figure 4 représente un autre exemple d'unité d'impédance active 108 configurée pour générer une impédance active avec une inductance positive $L_T$. La configuration de la figure 4 est celle d'un système gyrateur comprenant une résistance variable $R_1$, une capacité C, un amplificateur opérationnel et une résistance $R_2$. Pour changer la valeur la capacité de l'impédance active appliquée au résonateur piézoélectrique 102, la valeur de la résistance $R_1$ variable est changée. Par exemple, l'unité de contrôle 108, en déterminant la valeur d'impédance active, peut déterminer la valeur de la résistance variable $R_1$ en utilisant la relation : $L_T = CR_1R_2$.

De plus, comme indiqué ci-dessus, la valeur de la résistance peut être changée afin d'obtenir des valeurs d'impédance active $C_T$ discrètes ou continues, c'est-à-dire des valeurs continues dans une plage déterminée par l'unité de contrôle 106.

Ainsi, comme indiqué dans la figure 4, la configuration illustrée simule une inductance positive variable qui permet de changer la tension Vp en se combinant avec l'impédance intrinsèque Cp de l'élément piézoélectrique 114.

Les exemples d'unités d'impédance active 108 décrits ci-dessus permettent de générer une impédance destinée par exemple à maximiser la tension Vp, directement aux bornes des électrodes 112a, 112b du résonateur piézoélectrique 102. **En** particulier, la présente invention ne nécessite pas l'utilisation d'électrodes supplémentaires nécessaires pour les inventions utilisant des éléments passifs tels que « varicap » (capacités variables en fonction d'une tension appliquée à ses bornes). Ainsi, la présente invention permet de maximiser la surface de l'élément piézoélectrique 114.

De plus, les exemples décrits ci-dessus, permettent l'application d'une impédance allant au-delà de l'annulation de la capacité électrique Cp liée à l'élément piézoélectrique 114. Ainsi, la présente invention permet une plus grande variation de la tension Vp.

Alternativement, l'unité d'impédance active 108 de la figure 3 ou de la figure 4 peut générer deux impédances actives simultanément ou séquentiellement afin d'adapter la fréquence de résonance et le facteur de qualité. Par exemple, comme illustré dans la figure 5, une résistance variable $R_3$ et une impédance active $C_T$ peuvent être utilisées pour modifier le facteur de qualité et la fréquence de résonance. La résistance $R_3$ illustrée dans la figure 5 est une résistance positive permettant de modifier le facteur de qualité et d'adapter la fréquence de résonance. Dans un autre exemple, un circuit configuré pour générer une résistance négative peut être utilisé, qui permettrait de modifier le facteur de qualité et la fréquence de résonance. Alternativement, deux unités d'impédance active peuvent être utilisées, l'une générant une impédance active permettant de maximiser le facteur de qualité, l'autre générant une impédance active permettant d'adapter la fréquence de résonance.

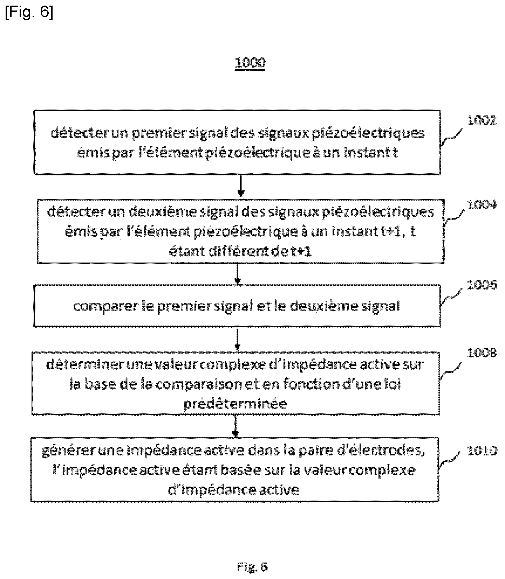

La figure 6 est un organigramme illustrant un procédé d'ajustement 1000 pour ajuster des signaux piézoélectrique d'un résonateur piézoélectrique 102 comprenant un élément piézoélectrique 114 et une paire d'électrodes 112a, 112b configurées pour transmettre des signaux piézoélectriques émis par l'élément piézoélectrique 114 et engendrés par une déformation de l'élément piézoélectrique 114. Par exemple, le procédé 1000 peut être implémenté par le système 100 décrit ci-dessus.

Dans l'étape 1002, un premier signal des signaux piézoélectriques émis par l'élément piézoélectrique 114 est détecté à un instant t. Par exemple, comme illustré dans la figure 2a, le signal Vp(t) est détecté à l'instant t et la valeur crête à crête Vpp(t) est mesurée.

Dans l'étape 1004, un deuxième signal des signaux piézoélectriques émis par l'élément piézoélectrique 114 est détecté à un instant t, t étant différent de t+1. Par exemple, comme illustré dans la figure 2a, le signal Vp(t+1) est détecté à l'instant t+1 et la valeur crête à crête Vpp(t+1) est mesurée.

Dans l'étape 1006, le premier signal et le deuxième signal sont comparés. Par exemple, comme illustré dans la figure 2b, le la valeur crête à crête Vpp(t+1) est supérieure à la valeur crête à crête Vpp(t).

Dans l'étape 1008, une valeur complexe d'impédance active $C_T$ est déterminée sur la base de la comparaison et en fonction d'une loi prédéterminée. Dans l'étape 1010, une impédance active est générée dans la paire d'électrodes112a, 112b, l'impédance active étant basée sur la valeur complexe d'impédance active $C_T$. Comme illustré dans la figure 2c, une valeur complexe d'impédance active 100 est déterminée et appliquée au résonateur piézoélectrique 102 afin de modifier la tension Vp.

Le procédé d'ajustement 1000 peut être répété successivement plusieurs fois et, chaque fois que le procédé 1000 est répété, le signal deuxième signal devient le premier signal. Par exemple, comme indiqué ci-dessus, en rapport avec la figure 2b, les tensions crête à crête Vpp(t) et Vpp(t+1) sont comparées. Comme Vpp(t1) est supérieur à Vpp(t), l'unité de contrôle 106 détermine une valeur d'impédance complexe $C_T$ afin de maximiser la valeur de la tension Vp. Une fois l'impédance $C_T$ générée et appliquée au résonateur piézoélectrique 102, les tensions crête à crête Vpp(t+1) et Vpp(t+2) sont comparées, et ainsi de suite.

Dans un exemple, le procédé d'ajustement 1000 est répété au moins trois fois et le premier signal, le deuxième signal et un troisième signal sont détectés successivement et le procédé est arrêté pendant une période prédéterminée quand le premier signal initial est sensiblement égal au troisième signal (dans un seuil de tolérance). Par exemple, comme illustré dans la figure 2a, le procédé 1000 est réalisé plusieurs fois. Spécifiquement, une impédance active 011 a été appliquée au résonateur piézoélectrique 102 afin d'obtenir la valeur crête à crête Vpp(t+3). Puis, une impédance active 100, inférieure à l'impédance active 011 a été appliquée au résonateur piézoélectrique 102 afin d'obtenir la valeur crête à crête Vpp(t+4). Cependant, la valeur crête à crête Vpp(t+4) est inférieure à la valeur crête à crête Vpp(t+3). Donc l'impédance active 011 est à nouveau appliquée au résonateur piézoélectrique 102. La valeur crête à crête Vpp(t+3) est égale à la valeur crête à crête Vpp(t+4). Ainsi, la tension Vp(t+4) est optimisée avec l'impédance active 011. Par conséquent, le système peut être arrêté pour une durée qui peut par exemple dépendre du résonateur piézoélectrique 102 ou être indiquée par un opérateur.

Bien que l'invention ait été illustrée et décrite en détail à l'aide d'un mode de réalisation préféré, l'invention n'est pas limitée aux exemples divulgués. D'autres variantes peuvent être déduites par l'homme du métier sans sortir du cadre de protection de l'invention revendiquée.

**Revendications**

**1.** Système piézoélectrique (100) comprenant:

- un résonateur piézoélectrique (102) comprenant un élément piézoélectrique (114) et une paire d'électrodes (112a, 112b) configurée pour transmettre des signaux émis par l'élément piézoélectrique et engendrés par une déformation mécanique de l'élément piézoélectrique ;

- un détecteur (104) configuré pour détecter au moins deux signaux des signaux engendrés par la déformation de l'élément piézoélectrique, les au moins deux signaux étant détectés à des instants différents ;

- une unité de contrôle (106) configurée pour comparer les aux moins deux signaux et, sur la base de la comparaison, déterminer une valeur complexe d'impédance active en fonction d'une loi prédéterminée ;

- une unité d'impédance active (108) configurée pour générer une impédance active basée sur la valeur complexe d'impédance active déterminée par l'unité de contrôle, l'unité d'impédance active (108) étant connectée à la paire d'électrodes (112a, 112b),

**caractérisé en ce que** l'impédance active comprend une capacité de valeur négative et **en ce que** une valeur absolue de la capacité de valeur négative est inférieure à une valeur absolue d'une capacité intrinsèque Cp de l'élément piézoélectrique.

2. Système piézoélectrique (100) selon la revendication 1, dans lequel le système (100) comprend une unité de mémoire (106) configurée pour sauvegarder les au moins deux signaux

3. Système piézoélectrique (100) selon la revendication 1 ou la revendication 2, dans lequel l'impédance active comprend une résistance et/ou une inductance et/ou une capacité.

4. Système piézoélectrique (100) selon l'une des revendications précédentes, dans lequel l'unité d'impédance active (108) comprend un amplificateur opérationnel (AO).

5. Système piézoélectrique (100) selon l'une des revendications précédentes, dans lequel l'unité de contrôle (106) est configurée pour augmenter une valeur de capacité de l'impédance active quand un premier signal des au moins deux signaux est supérieur à un deuxième signal des au moins deux signaux, et réduire une valeur de capacité de l'impédance quand le premier signal est inférieur au deuxième signal, dans lequel le premier signal est détecté à un premier instant et le deuxième signal est détecté à un deuxième instant, le premier instant précédant le deuxième instant.

6. Système piézoélectrique (100) selon l'une des revendications précédentes, dans lequel le détecteur (104) est configuré pour attendre une durée prédéterminée entre la détection du premier signal et la détection du deuxième signal.

7. Procédé d'ajustement pour ajuster des signaux piézoélectrique d'un résonateur piézoélectrique (102) comprenant un élément piézoélectrique (114) et une paire d'électrodes (112a, 112b) configurées pour transmettre des signaux piézoélectriques émis par l'élément piézoélectrique (102) et engendrés par une déformation mécanique de l'élément piézoélectrique (102), le procédé comprenant:

- détecter un premier signal des signaux piézoélectriques émis par l'élément piézoélectrique (114) à un instant t ;

- détecter un deuxième signal des signaux piézoélectriques émis par l'élément piézoélectrique à un instant t+1, t étant différent de t+1;

- comparer le premier signal et le deuxième signal ;

- déterminer une valeur complexe d'impédance active sur la base de la comparaison et en fonction d'une loi prédéterminée; et

- générer une impédance active dans **la** paire d'électrodes (112a, 112b), l'impédance active étant basée sur la valeur complexe d'impédance active; l'impédance active comprend une capacité de valeur négative, une valeur absolue de la capacité de valeur négative est inférieure à une valeur absolue d'une capacité intrinsèque Cp de l'élément piézoélectrique.

8. Procédé d'ajustement selon la revendication 7, dans lequel le procédé est répété successivement plusieurs fois et, chaque fois que le procédé est répété, le premier signal devient le deuxième signal.

9. Procédé d'ajustement selon la revendication 8, dans lequel le procédé est répété au moins trois fois et le premier signal, le deuxième signal et un troisième signal sont détectés successivement, le procédé comprenant:

- arrêter le procédé pendant une période prédéterminée quand le signal initial est sensiblement égal au troisième signal.

**Patentansprüche**

1. Piezoelektrisches System (100), das Folgendes umfasst:

- einen piezoelektrischen Resonator (102), der ein piezoelektrisches Element (114) und ein Elektrodenpaar (112a, 112b) umfasst, das zum Übertragen von durch das piezoelektrische Element emittierten und durch eine mechanische Verformung des piezoelektrischen Elements verursachten Signalen konfiguriert ist,

- einen Detektor (104), der zum Erfassen von mindestens zwei Signalen der durch die Verformung des piezoelektrischen Elements verursachten Signale konfiguriert ist, wobei die mindestens zwei Signale zu verschiedenen Zeitpunkten erfasst werden,

- eine Steuereinheit (106), die zum Vergleichen der mindestens zwei Signale und zum Bestimmen, auf der Basis des Vergleichs, eines komplexen Werts von aktiver Impedanz als Funktion eines vorbestimmten Gesetzes konfiguriert ist,

- eine aktive Impedanzeinheit (108), die zum Erzeugen einer aktiven Impedanz auf der Basis des von der Steuereinheit bestimmten komplexen Werts von aktiver Impedanz konfiguriert ist, wobei die aktive Impedanzeinheit (108) mit dem Elektrodenpaar (112a, 112b) verbunden ist, **dadurch gekennzeichnet, dass** die aktive Impedanz eine Kapazität negativen Werts umfasst, und dadurch, dass ein Absolutwert Kapazität negativen Werts kleiner ist als ein Absolutwert einer intrinsischen Kapazität Cp des piezoelektrischen Elements.

2. Piezoelektrisches System (100) nach Anspruch 1, wobei das System (100) eine Speichereinheit (106) umfasst, die zum Speichern der mindestens zwei Signale konfiguriert ist.

3. Piezoelektrisches System (100) nach Anspruch 1 oder Anspruch 2, wobei die aktive Impedanz einen Widerstand und/oder eine Induktivität und/oder eine Kapazität umfasst.

4. Piezoelektrisches System (100) nach einem der vorhergehenden Ansprüche, wobei die aktive Impedanzeinheit (108) einen Operationsverstärker (AO) umfasst.

5. Piezoelektrisches System (100) nach einem der vorhergehenden Ansprüche, wobei die Steuereinheit (106) konfiguriert ist zum Erhöhen eines Kapazitätswerts der aktiven Impedanz, wenn ein erstes Signal der mindestens zwei Signale größer ist als ein zweites Signal der mindestens zwei Signale, und zum Verringern eines Kapazitätswerts der Impedanz, wenn das erste Signal kleiner als das zweite Signal ist, wobei das erste Signal zu einem ersten Zeitpunkt erfasst wird und das zweite Signal zu einem zweiten Zeitpunkt erfasst wird, wobei der erste Zeitpunkt vor dem zweiten Zeitpunkt liegt.

6. Piezoelektrisches System (100) nach einem der vorhergehenden Ansprüche, wobei der Detektor (104) zum Warten für eine vorbestimmte Zeit zwischen der Erfassung des ersten Signals und der Erfassung des zweiten Signals konfiguriert ist.

7. Justierverfahren zum Justieren piezoelektrischer Signale eines piezoelektrischen Resonators (102), der ein piezoelektrisches Element (114) und ein Elektrodenpaar (112a, 112b) umfasst, die zum Übertragen von durch das piezoelektrische Element (102) emittierten und durch eine mechanische Verformung des piezoelektrischen Elements (102) verursachten piezoelektrischen Signalen konfiguriert sind,

wobei das Verfahren Folgendes umfasst:

- Erfassen eines ersten Signals der durch das piezoelektrische Element (114) zu einem Zeitpunkt t emittierten piezoelektrischen Signale,
- Erfassen eines zweiten Signals der durch das piezoelektrische Element zu einem Zeitpunkt t+1 emittierten piezoelektrischen Signale, wobei t von t+1 verschieden ist,
- Vergleichen des ersten Signals und des zweiten Signals;
- Bestimmen eines komplexen Werts von aktiver Impedanz auf der Basis des Vergleichs und als Funktion eines vorbestimmten Gesetzes; und
- Erzeugen einer aktiven Impedanz in dem Elektrodenpaar (112a, 112b), wobei die aktive Impedanz auf dem komplexen Wert von aktiver Impedanz basiert; die aktive Impedanz eine Kapazität negativen Werts umfasst, ein Absolutwert der Kapazität negativen Werts kleiner ist als ein Absolutwert einer intrinsischen Kapazität Cp des piezoelektrischen Elements.

8. Justierverfahren nach Anspruch 7, wobei das Verfahren mehrmals nacheinander wiederholt wird und bei jeder Wiederholung des Verfahrens das erste Signal zum zweiten Signal wird.

9. Justierverfahren nach Anspruch 8, wobei das Verfahren mindestens dreimal wiederholt wird und das erste Signal, das zweite Signal und ein drittes Signal nacheinander erfasst werden, wobei das Verfahren Folgendes umfasst:

- Stoppen des Verfahrens für eine vorbestimmte Zeitdauer, wenn das Anfangssignal im Wesentlichen gleich dem dritten Signal ist.

**Claims**

1. A piezoelectric system (100) comprising:

- a piezoelectric resonator (102) comprising a piezoelectric element (114) and a pair of electrodes (112a, 112b) configured to transmit signals emitted by the piezoelectric element and caused by a mechanical deformation of the piezoelectric element;

- a detector (104) configured to detect at least two signals of the signals caused by the deformation of the piezoelectric element, the at least two signals being detected at different times;

- a control unit (106) configured to compare the at least two signals and, on the basis of the comparison, determine a complex active impedance value as a function of a predetermined law;

- an active impedance unit (108) configured to generate an active impedance based on the complex active impedance value determined by the control unit, the active impedance unit (108) being connected to the pair of electrodes (112a, 112b), **characterized in that** the active impedance comprises a negative value capacitance and **in that** an absolute value of the negative value capacitance is less than an absolute value of an intrinsic capacitance Cp of the piezoelectric element.

2. The piezoelectric system (100) according to claim 1, wherein the system (100) comprises a memory unit (106) configured to save the at least two signals.

3. The piezoelectric system (100) according to claim 1 or claim 2, wherein the active impedance comprises a resistance and/or an inductance and/or a capacitance.

4. The piezoelectric system (100) according to one of the preceding claims, wherein the active impedance unit (108) comprises an operational amplifier (OA).

5. The piezoelectric system (100) according to one of the preceding claims, wherein the control unit (106) is configured to increase a capacitance value of the active impedance when a first signal of the at least two signals is greater than a second signal of the at least two signals, and reduce a capacitance value of the impedance when the first signal is less than the second signal, wherein the first signal is detected at a first time and the second signal is detected at a second time, the first time preceding the second time.

6. The piezoelectric system (100) according to one of the preceding claims, wherein the detector (104) is configured to wait for a predetermined duration between the detection of the first signal and the detection of the second signal.

7. An adjustment method for adjusting piezoelectric signals of a piezoelectric resonator (102) comprising a piezoelectric element (114) and a pair of electrodes (112a, 112b) configured to transmit piezoelectric signals emitted by the piezoelectric element (102) and caused by a mechanical deformation of the piezoelectric element (102), the method comprising:

- detecting a first signal of the piezoelectric signals emitted by the piezoelectric element (114) at a time t;
- detecting a second signal of the piezoelectric signals emitted by the piezoelectric element at a time t+1, t being different from t+1;
- comparing the first signal and the second signal;
- determining a complex active impedance value based on the comparison and as a function of a predetermined law; and
- generating an active impedance in the pair of electrodes (112a, 112b), the active impedance being based on the complex active impedance value; the active impedance comprising a negative value capacitance, an absolute value of the negative value capacitance being less than an absolute value of an intrinsic capacitance Cp of the piezoelectric element.

8. The adjustment method according to claim 7, wherein the method is repeated successively several times and, each time the method is repeated, the first signal becomes the second signal.

9. The adjustment method according to claim 8, wherein the method is repeated at least three times and the first signal, the second signal and a third signal are detected successively, the method comprising:

- stopping the method for a predetermined period when the initial signal is substantially equal to the third signal.

[Fig. 1]

100

Fig. 1

[Fig. 2a]

[Fig. 2b, 2c, 2d]

Fig. 2b

Fig. 2c

Fig. 2d

[Fig. 3]

Fig. 3

[Fig. 4]

Fig. 4

[Fig. 5]

Fig. 5

[Fig. 6]

<u>1000</u>

détecter un premier signal des signaux piézoélectriques émis par l'élément piézoélectrique à un instant t — 1002

↓

détecter un deuxième signal des signaux piézoélectriques émis par l'élément piézoélectrique à un instant t+1, t étant différent de t+1 — 1004

↓

comparer le premier signal et le deuxième signal — 1006

↓

déterminer une valeur complexe d'impédance active sur la base de la comparaison et en fonction d'une loi prédéterminée — 1008

↓

générer une impédance active dans la paire d'électrodes, l'impédance active étant basée sur la valeur complexe d'impédance active — 1010

Fig. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007103650 A1
- FR 2962613 A1
- WO 2019073066 A1